# EUROPÄISCHE PATENTSCHRIFT

(11) **EP 1 403 898 B1**
(45) Veröffentlichungstag und Bekanntmachung des Hinweises auf die Patenterteilung: **10.08.2011**
(21) Anmeldenummer: 03021570.1
(22) Anmeldetag: 24.09.2003
(51) Int. Cl.: H01J 1/34, H01J 37/073, H01J 37/075, H01J 3/02

(54) **Elektronenstrahlquelle und elektronenoptischer Apparat mit einer Elektronenstrahlquelle und Verfahren zum Betrieb einer Elektronenstrahlquelle**
Electron beam source, electron-optical apparatus comprising an electron beam source and method of operating an electron beam source
Source d'électrons, appareil optique à électrons comprenant une source d'électrons et méthode de fonctionnement d'une source d'électrons

(30) Priorität: 26.09.2002 DE 10245052
(43) Veröffentlichungstag der Anmeldung: 31.03.2004
(73) Patentinhaber: Carl Zeiss NTS GmbH, 73447 Oberkochen (DE)
(72) Erfinder: Steigerwald, Michael, Dr., 73434 Aalen (DE)
(74) Vertreter: Schorr, Frank Jürgen

(56) Entgegenhaltungen:
- DE-A1- 19 604 272
- JP-A- 5 159 694
- JP-A- 7 014 503
- JP-A- 9 063 468
- US-A- 4 096 386
- SCHAEFER B ET AL: "LASER DRIVEN THERMIONIC ELECTRON GUN" OPTIK, WISSENSCHAFTLICHE VERLAG GMBH.STUTTGART, Bd. 92, Nr. 1, 1. November 1992 (1992-11-01), Seiten 9-13, XP000321915 ISSN: 0030-4026
- MOELLENSTEDT G ET AL: "DIE ANWENDUNG EINES FOKUSSIERTEN LASERSTRAHLS ZUR HEIZUNG DER KATHODE EINES ELEKTRONENSTRAHL-ERZEUGUNGSSYSTEMS. USE OF A FOCUSSEDLASER BEAM FOR HEATING THE CATHODE OF AN ELECTRON GUN" OPTIK, WISSENSCHAFTLICHE VERLAG GMBH.STUTTGART, Bd. 51, Nr. 4, 1. Oktober 1978 (1978-10-01), Seiten 417-421, XP002052127 ISSN: 0030-4026
- BOSTANJOGLO O ET AL: "A REFLECTION ELECTRON MICROSCOPE FOR IMAGING OF FAST PHASE TRANSISTIONS ON SURFACES" REVIEW OF SCIENTIFIC INSTRUMENTS, AIP, MELVILLE, NY, US, Bd. 61, Nr. 4, 1. April 1990 (1990-04-01), Seiten 1223-1229, XP000114712 ISSN: 0034-6748
- O'SHEA P G ET AL: "RADIO FREQUENCY PHOTOINJECTOR USING LAB6 CATHODE AND A NITROGEN DRIVE LASER" APPLIED PHYSICS LETTERS, AIP, AMERICAN INSTITUTE OF PHYSICS, MELVILLE, NY, Bd. 73, Nr. 3, 20. Juli 1998 (1998-07-20), Seiten 411-413, XP000776739 ISSN: 0003-6951

## Beschreibung

Die Erfindung betrifft eine Elektronenstrahlquelle und einen elektronenoptischen Apparat mit einer solchen Elektronenstrahlquelle.

Elektronenoptische Apparate, wie beispielsweise Elektronenmikroskope oder Lithographievorrichtungen, welche Elektronen zur Abbildung eines Musters auf einem Substrat einsetzen, umfassen wenigstens eine Elektronenstrahlquelle, um einen Elektronenstrahl bereitzustellen, welcher in dem Apparat für eine elektronenoptische Abbildung oder andere Zwecke eingesetzt wird.

Typische Anforderungen an eine Elektronenstrahlquelle sind die Bereitstellung eines Elektronenstrahls mit hohem Strahlstrom oder/und mit hoher Brillianz ("brightness") oder/und mit guter zeitlicher Konstanz der Intensität oder/und mit einer kleinen Breite (FWHM, "full width at half maximum") der Verteilung der kinetischen Energie der Elektronen in dem bereitgestellten Elektronenstrahl.

Eine typische Elektronenstrahlquelle umfasst einen Kathodenkörper mit einer Quelloberfläche, von der die Elektronen emittiert werden, und einer mit Abstand von der Quelloberfläche angeordnete Anode zur Bereitstellung eines elektrischen Extraktionsfeldes, um die Emission der Elektronen zu unterstützen. Es kann auch eine Heizeinrichtung vorgesehen sein, um die Quelloberfläche zu heizen und hierdurch die Emission der Elektronen ebenfalls zu unterstützen.

Je nach Stärke des Extraktionsfeldes bzw. der Höhe der Temperatur der Quelloberfläche werden verschiedene physikalische Prozesse unterschieden, welche die Emission der Elektronen von der Oberfläche hervorrufen (siehe z.B. Reimer, Scanning Electron Microscopy: Physics of Image Formation and Microanalysis, 2^{nd} edition, Springer series in optical sciences, 1998) . Um sich von der Oberfläche zu entfernen, muss das Elektron eine Potentialbarriere überwinden, welche als Arbeitsfunktion bzw. work function φ_{w} oder als chemisches Potential µₑ bezeichnet wird.

Ist die Temperatur der Quelloberfläche so hoch, dass Elektronen die Potentialbarriere vom Fermi-Niveau E_{F} des Kathodenmaterials durch thermische Anregung überwinden können, so spricht man von einem thermischen Emissionsprozess. Solche Bedingungen werden beispielsweise bei einer Wolfram-Kathode bei einer Temperatur des Kathodenmaterials von 2500 K bis 3000 K erreicht.

Bei niedrigen Temperaturen der Quelloberfläche derart, dass thermische Anregungsprozesse zur Emission der Elektronen eine geringe Rolle spielen, und ein starkes elektrisches Extraktionsfeld angelegt ist, dominiert ein Feldemissionsprozess, und im wesentlichen nach diesem Prinzip arbeitende Quellen werden als Feldemissionsquellen bezeichnet. Hierzu notwendige elektrische Feldstärken liegen in der Regel bei über 10⁷ V/cm. Eine Erklärung für diesen Prozess ist derart, dass das starke elektrische Feld wohl auch zu einer gewissen Absenkung der Potentialbarriere führt, diese durch die Feldwirkung so schmal wird, dass sie von den emittierten Elektronen durch einen Tunneleffekt überwunden werden kann.

Ferner sind noch als Schottky-Quellen bezeichnete Elektronenstrahlquellen bekannt, welche eine Erniedrigung der Potentialbarriere durch den Schottky-Effekt ausnutzen. Bei einer solchen Quelle ist typischerweise das elektrische Extraktionsfeld etwa zehn mal kleiner als bei einer Feldemissionsquelle, so dass keine ausreichende Verschmälerung der Potentialbarriere zur nennenswerten Förderung eines Tunneleffekts auftritt. Eine solche Quelle wird zusätzlich geheizt, allerdings auf eine Temperatur, die niedriger ist, als bei einer vergleichbaren thermischen Emissionsquelle. Die Temperatur ist jedoch ausreichend hoch, so dass die Elektronen durch thermische Anregung die durch den Schottky-Effekt abgesenkte Potentialbarriere überwinden können.

Im Hinblick auf eine geringe Energiebreite (FWHM) der Quelle sollte die Quelloberfläche eine niedrige Temperatur aufweisen, um eine thermische Verbreiterung der Energiebreite möglichst gering zu halten. Unter diesem Gesichtspunkt wären Feldemissionsquellen zu bevorzugen, welche bei Raumtemperatur der Quelloberfläche betreibbar sind. Allerdings benötigen diese ein äußerst gutes Vakuum, um die Quelloberfläche nicht durch Ionenbombardierung zu zerstören. Ferner sind diese Quellen hinsichtlich der maximalen Strahlintensität limitiert.

Schottky-Quellen stellen hier typischerweise einen oft akzeptablen Kompromiss zwischen niedriger Temperatur der Quelloberfläche im Hinblick auf die Energieverbreiterung und Vermeidung eines äußerst guten Vakuums bereit. Allerdings sind diese Quellen, insbesondere dann, wenn sie bei niedriger Temperatur betrieben werden, im Hinblick auf die zeitliche Konstanz der Strahlintensität etwas nachteilhaft, da bereits sehr geringe Änderungen von Umgebungsparametern, wie etwa Temperaturänderungen und Oberflächenkontaminationen und der gleichen, zu vergleichsweise großen Intensitätsschwankungen führen.

Ferner sind z.B. aus US 4,460,831 oder US 5,808,309 Elektronenstrahlquellen bekannt, bei denen die Quelloberfläche mit einem Photonenstrahl beleuchtet wird, um aus der Oberfläche Elektronen unter Ausnutzung eines Photoeffekts auszulösen. Derartige Quellen werden dort eingesetzt, wo der Elektronenstrahl schnell an- und ausschaltbar sein soll, da schnell schaltbare Lichtquellen existieren, und die Elektronenstrahlintensität unmittelbar der geschalteten Lichtintensität folgt. Allerdings setzt eine solche Photoemissionsquelle bei üblichen Materialien der Quelloberfläche die Bestrahlung mit Licht besonders kurzer Wellenlänge voraus, da die Energie der Lichtquanten größer sein muss als die Höhe der Potentialbarriere. Derartige Lichtquellen mit ausreichender Intensität sind allerdings aufwendig in der Beschaffung und im Betrieb.

Aus US 5,041,724 ist eine schnell an- und ausschaltbare Photoemissionsquelle bekannt, bei der die Energie der für die Photoemission notwendigen Photonen herabgesetzt bzw. die Wellenlänge des Lichts vergrößert ist, indem die Höhe der zu überwindenden Potentialbarriere erniedrigt ist durch ein zusätzliches starkes Extraktionsfeld, was zu einer sogenannten feldunterstützten Photoemission ("field assisted photo emission") führt, oder indem die Quelloberfläche zusätzlich geheizt wird, was zu einer thermisch unterstützten Photoemission ("thermally assisted photo emission") führt.

Ferner ist es beispielsweise aus US 5,763,880 bekannt, die Potentialbarriere bzw. Austrittsarbeit eines Kathodenkörpers dadurch herabzusetzen, dass dessen Quelloberfläche mit einem Oxid oder Nitrid belegt wird.

In der Veröffentlichung von B. Schaefer et al: "Laser Driven Thermionic Electron Gun" Optik, Wissenschaftlicher

Verlag GmbH. Stuttgart, Bd. 92, Nr. 1, 1. November 1992 (1992-11-01), Seiten 9 bis 13, wird eine Lasergetriebene thermionische Elektronenquelle beschrieben, bei der eine Wehneltelektrode durch gepulste Laserstrahlen geheizt wird.

In der Veröffentlichung von G. Möllenstedt et al: "Die Anwendung eines fokussierten Laserstrahls zur Heizung der Kathode eines Elektronenstrahl-Erzeugungssystems" Optik, Wissenschaftlicher Verlag GmbH. Stuttgart, Bd. 51, Nr. 4, 1. Oktober 1978 (1978-10-01), Seiten 417 bis 421, wird eine Wolframdrahtspitze der Größenordnung von einigen 100 nm mit einem Laser geheizt. Ein Teil der Elektronen des erzeugten Elektronenstrahls treffen auf eine Messblende, wodurch ein Messsignal erzeugt wird. Basierend auf dem Messsignal wird die Intensität des Lasers nachgeregelt.

Wie vorangehend bereits erläutert, weisen Quellen mit niedriger Temperatur aufgrund des höheren Beitrags eines Tunneleffekts zur Elektronenemission das Problem einer nicht optimal reproduzierbaren Strahlintensität auf.

Demgemäß ist es eine Aufgabe der vorliegenden Erfindung, eine Elektronenstrahlquelle mit einer vergleichsweise niedrigen Temperatur der Quelloberfläche und gleichzeitig einer vergleichsweise guten Einstellbarkeit einer gewünschten Strahlintensität vorzuschlagen.

Ferner ist es eine Aufgabe der vorliegenden Erfindung, einen elektronenmikroskopischen Apparat, insbesondere ein Elektronenmikroskop, vorzuschlagen, welcher einen Elektronenstrahl mit vergleichsweise geringer Energiebreite und vergleichsweise guter Einstellbarkeit des Strahlstromes ermöglicht.

Die Erfindung sieht hierzu eine Elektronenstrahlquelle zur Erzeugung eines Strahls von Elektronen vor, welche einen Kathodenkörper mit einer Quelloberfläche zur Emission von Elektronen und eine mit Abstand von dem Kathodenkörper angeordneten Anode zur Bereitstellung eines Extraktionsfeldes umfasst. Das Extraktionsfeld ist vorgesehen, um die Elektronen im Hinblick auf die Überwindung der Potentialbarriere zu unterstützen, also um die Potentialbarriere durch die Feldwirkung wenigstens etwas abzusenken, wie dies vorangehend im Zusammenhang mit dem Schottky-Effekt beschrieben wurde, bzw. um die Potentialbarriere zu verschmälern, so dass gegebenenfalls auch ein Tunnelprozess bei der Emission der Elektronen eine gewisse Rolle spielen kann, wie dies vorangehend im Zusammenhang mit dem Feldemissionsprozess beschrieben wurde.

Die Elektronenstrahlquelle umfasst ferner eine Photonenquelle zur Erzeugung wenigstens eines auf die Quelloberfläche gerichteten Photonenstrahls, um die Emission der Elektronen durch einen Photoemissionsprozess ebenfalls zu unterstützen, wie dies vorangehend im Zusammenhang mit dem Photoeffekt beschrieben wurde. Somit wirken wenigstens das Extraktionsfeld und der Photonenstrahl zusammen, um die Elektronen aus der Quelloberfläche auszulösen.

Im Hinblick auf eine geringe Intensität des Photonenstrahls und eine geringere Energie der Lichtquanten des Photonenstrahls bzw. eine größere Wellenlänge derselben, ist vorzugsweise eine Heizeinrichtung vorgesehen, um den Kathodenkörper zu heizen, so dass auch eine thermische Anregung der Elektronen zur Emission derselben aus der Quelloberfläche beiträgt.

Hierbei ist es möglich, die Elektronenstrahlquelle dem Typ der herkömmlichen Schottky-Quelle derart anzunähern, dass der thermische Emissionsprozess einen maßgeblichen Anteil an der Elektronenemission aufweist und die Elektronenstrahlquelle einen wesentlichen Elektronenstrahl, das heißt einen von einem Dunkelstrom abweichenden Elektronenstrahl, auch dann emittiert, wenn die Photonenquelle abgeschaltet ist. Es kann dann ein großer Teil der zur Emission der Elektronen notwendigen Energie durch die im Vergleich zu der Photonenquelle einfache Heizeinrichtung bereitgestellt werden und die Photonenquelle hauptsächlich im Hinblick auf die gewünschte Einstellung, insbesondere Konstanthaltung, der Intensität des Elektronenstrahls verwendet werden.

Selbst wenn sich die Quelloberfläche aufgrund der Bestrahlung mit dem Photonenstrahl aufgrund von Energiedeposition über Raumtemperatur erwärmt und somit auch die auf den Photonenstrahl zurückzuführende Erwärmung der Oberfläche einen thermischen Beitrag zu dem Emissionsprozess leistet, so ist dieser Beitrag vergleichsweise gering. Eine maximale Intensität des Photonenstrahls in einem Normalbetriebsmodus der Elektronenstrahlquelle ist vorzugsweise derart beschränkt, dass sich die Quelloberfläche, ausgehend von Raumtemperatur, nicht über eine Temperatur von 1700 K, insbesondere nicht über 1200 K und weiter bevorzugt nicht über 700 K erhöhen würde, wenn auf die Quelloberfläche alleine der Photonenstrahl fallen würde und dem Kathodenkörper sonst aktiv keine weitere Energie, beispielsweise durch eine zusätzlich Heizung oder dergleichen, zugeführt werden würde.

Der Photonenstrahl spielt allerdings erfindungsgemäß eine große Rolle im Hinblick auf die Einstellung der Intensität des emittierten Elektronenstrahls, da diese Elektronenstrahlintensität über eine Änderung der Intensität des Photonenstrahls eingestellt wird. Hierzu umfasst die Elektronenstrahlquelle weiter eine Messeinrichtung zur Erfassung eines Strahlstroms des Elektronenstrahls und zur Ausgabe eines den Strahlstrom repräsentierenden Messsignals sowie weiter eine Steuerung, die das Messsignal erfasst und auf die Photonenquelle im Normalbetriebsmodus der Elektronenstrahlquelle einwirkt, um die Intensität des Photonenstrahls in Abhängigkeit von dem Messsignal zu ändern.

Damit wird die einzustellende Größe, nämlich die Intensität des Elektronenstrahls selbst, als Messgröße verwendet, um auf den Photonenstrahl als Stellgröße einzuwirken, und zwar dahingehend, um die Elektronenstrahlintensität in einer gewünschten Weise zu steuern. Die Steuerung kann unter anderem im Hinblick auf eine zeitliche Konstanz der Elektronenstrahlintensität erfolgen, sie kann allerdings unter anderem auch im Hinblick auf einen gewünschten integralen Strahlstrom, d.h. eine abgegebene Ladung der Elektronenstrahlquelle, erfolgen. Somit ist es möglich, Schwankungen der Elektronenstrahlquelle, welche dann auftreten würden, wenn die Intensität des Photonenstrahls nicht in Abhängigkeit von der Elektronenstrahlintensität gesteuert werden würde, auszugleichen bzw. zu kompensieren. Derartige Schwankungen können beispielsweise auf kleine Schwankungen der Temperatur der Quelloberfläche oder von Oberflächenkontaminationen zurückzuführen sein, deren Auswirkungen dann besonders hoch sind, wenn die Temperatur der Quelloberfläche im Normalbetrieb besonders niedrig ist.

Hierbei ist es bevorzugt, das Material der Quelloberfläche, das Extraktionsfeld, das Heizen des Kathodenkörpers und die Intensität des Photonenstrahls in dem Normalbetrieb der Elektronenstrahlquelle derart aufeinander abzustimmen, dass der Strahlstrom des Elektronenstrahls bei abgeschalteter Photonenquelle mehr als 30 %, insbesondere mehr als 65 % und weiter bevorzugt mehr als 80 % des Strahlstroms in dem Normalbetriebsmodus der Elektronenstrahlquelle mit eingeschalteter Photonenquelle beträgt.

Die Heizeinrichtung kann vorzugsweise eine elektrische Heizeinrichtung umfassen, so dass die Erwärmung des Kathodenkörpers durch einen Ohm'schen Widerstand erfolgt.

Die Elektronenstrahlintensität kann durch die Messeinrichtung besonders einfach dadurch erfasst werden, dass die Intensität von auf eine Strahlblende treffenden Elektronen erfasst wird, also ein von dieser Strahlblende abfließender Strom gemessen wird. Die Strahlblende kann insbesondere die Anode zur Bereitstellung des Extraktionsfeldes sein.

Die Quelloberfläche des Kathodenkörpers umfasst bevorzugterweise Bariumoxid und ist weiter bevorzugt im wesentlichen durch Bariumoxid bereitgestellt, da dieses Material eine besonders niedrige Austrittsarbeit aufweist. Das Bariumoxid ist vorzugsweise auf einem Kathodenkörper aus beispielsweise Wolfram aufgebracht.

Gemäß einer Ausführungsform der Erfindung ist auch vorgesehen, den Photonenstrahl neben seiner Funktion zur Einstellung der Elektronenstrahlintensität im Normalbetrieb noch für einen weiteren Zweck einzusetzen, nämlich zum Ausheizen der Quelloberfläche und des die Quelloberfläche bereitstellenden Teils des Kathodenkörpers. Im Normalbetrieb können nämlich Änderungen an einer Soll-Konfiguration der Quelloberfläche auftreten, wie beispielsweise Abscheidung von Ionen aus dem Restgas einer Vakuumkammer, in der die Elektronenstrahlquelle betrieben wird. Derartige Veränderungen können durch Ausheizen der Quelloberfläche wieder rückgängig gemacht werden, indem in einem vom Normalbetrieb der Quelle abweichenden Ausheizbetriebsmodus die Intensität des Photonenstrahls derart erhöht wird, dass die Temperatur der Quelloberfläche die Arbeitstemperatur derselben im Normalbetrieb um mehr als 100 K, insbesondere um mehr als 200 K und weiter bevorzugt um mehr als 300 K oder mehr als 500 K übersteigt.

Die Erfindung sieht ferner den Einsatz der Elektronenstrahlquelle in einem elektronenoptischen Apparat vor. Der elektronenoptische Apparat umfasst insbesondere ein Elektronenmikroskop oder/und einen Elektronenlithographieapparat.

Ausführungsformen der Erfindung werden nachfolgend anhand von Zeichnungen näher erläutert. Hierbei zeigt:
- Figur 1: eine Elektronenstrahlquelle gemäß einer Ausführungsform der Erfindung und
- Figur 2: eine Elektronenstrahlquelle gemäß einer weiteren Ausführungsform der Erfindung, welche in einem erfindungsgemäßen elektronenoptischen Apparat angeordnet ist.

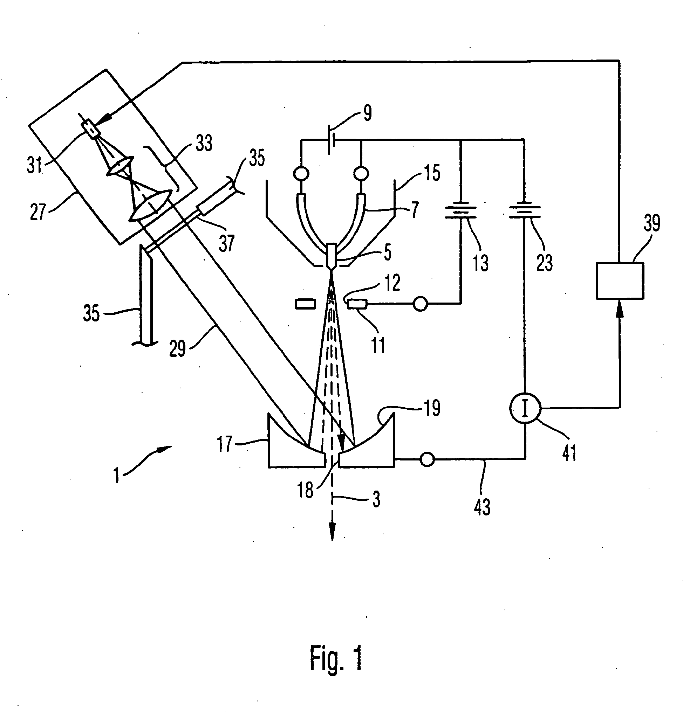

Eine in Figur 1 gezeigte Elektronenstrahlquelle 1 dient zur Bereitstellung eines Elektronenstrahls 3 einer vorbestimmten kinetischen Energie. Hierzu umfasst die Elektronenstrahlquelle 1 einen thermisch geheizten Kathodenkörper 5, welcher an einem V-förmig geformten Heizdraht 7 an der Spitze des V angebracht ist. Der Heizdraht 7 wird von einem Heizstrom durchflossen, welcher von einer Stromquelle 9 bereitgestellt wird. Der Kathodenkörper 5 ist an einem Ende zu einer Spitze ausgeformt, welche in Richtung des emittierten Elektronenstrahls 3 orientiert ist. Die Spitze des Kathodenkörpers 5 weist vor ihrem langgezogenen Ende einen Durchmesser von etwa 1 µm auf und stellt die eigentliche Quelloberfläche des Kathodenkörpers 5 bereit, d.h. die Oberfläche, von der die den Strahl 3 bildenden Elektronen austreten. Die Spitze des Kathodenkörpers kann auch an einem langgestreckten Drahtstück eines Durchmessers von 5 mm oder weniger, insbesondere 3 mm oder weniger oder gar 1 mm oder weniger vorgesehen sein.

Der Kathodenkörper 5 ist aus Wolfram gefertigt, und seine Oberfläche und insbesondere die Quelloberfläche sind mit einer Schicht aus Bariumoxid versehen, so dass die Quelloberfläche eine wesentlich kleinere Austrittsarbeit als Wolfram selbst und, je nach Präperationszustand, von etwa 1,5 eV bis 2,0 eV aufweist. Die Beschichtung der Quelloberfläche mit Bariumoxid kann nach einem ähnlichen Verfahren erfolgen, wie dies in US 5,763,880 für andere Materialien beschrieben ist.

Allerdings ist Bariumoxid in der Umgebungsluft nicht vollständig stabil, so dass die Präparation der Quelloberfläche vorzugsweise im Vakuum erfolgt. Dies kann beispielsweise dadurch erfolgen, dass auf dem Wolframkörper 5 ein Barium-Reservoir, beispielsweise in Form eines um den Körper gewickelten Bariumdrahtes, aufgebracht wird, der Wolframkörper 5 sodann durch Stromfluss erhitzt wird und in das Vakuumvolumen sodann Sauerstoff zugeführt wird, so dass das Barium oxidiert und das Oxid sich auf der Oberfläche des Körpers ausbreitet.

Es ist möglich, die Quelloberfläche separat von der Elektronenstrahlquelle 1 zu fertigen und den Kathodenkörper dann in einem Vakuumgefäß zu der Quelle zu transportieren und die Quelle durch eine Vakuumschleuse der Quelle in diese einzuführen. Es ist jedoch auch möglich, den Kathodenkörper an Ort und Stelle in der Elektronenstrahlquelle zu präparieren, indem der mit dem Barium-Reservoir versehene Kathodenkörper in der Quelle montiert wird und das Erhitzen des Kathodenkörpers in dem Vakuum der Quelle selbst erfolgt, wobei Sauerstoff durch eine in Figur 1 nicht dargestellte Zuleitung in die Nähe des Kathodenkörpers transportiert wird. Im Normalbetrieb wird die Quelle bei einem Vakuum einer Größenordnung von etwa 10⁻⁸ mbar betrieben.

Mit Abstand von der Quelloberfläche ist eine Anodenblende 11 angeordnet, um zwischen der Quelloberfläche und der Anodenblende 11 ein elektrisches Extraktionsfeld durch eine Hochspannungsquelle 13 bereitzustellen. Die Anodenblende 11 weist eine Öffnung 12 für den Durchtritt des Elektronenstrahls 3 auf, und der Kathodenkörper 5 und der Heizdraht 7 sind von einer sogenannten Supressorelektrode 15 umgeben, welche durch eine in Figur 1 nicht gezeigte Spannungsquelle auf ein geeignetes elektrisches Potential gebracht wird, um zwischen der Kathodenspitze mit der Quelloberfläche und der Anodenblende 11 das elektrische Extraktionsfeld so zu formen, dass die von der Quelloberfläche austretenden Elektronen durch die Öffnung 12 in der Anodenblende 11 geführt und dabei auch etwas fokussiert werden, um den Elektronenstrahl 3 zu formen.

Nach Durchlaufen der Anodenblende 11 durchsetzt der Elektronenstrahl 3 eine weitere Blendenelektrode 17 durch eine Ausnehmung 18 derselben. Die metallische Blendenelektrode 17 weist eine der Quelloberfläche zugewandte parabolförmige Oberfläche 19 auf, welche derart geformt und relativ zu der Spitze des Kathodenkörpers 5 angeordnet ist, dass ein Abstand zwischen der Quelloberfläche und dem Parabelboden zweimal so groß ist wie ein Krümmungsradius des Parabolspiegels am Ort des Parabelbodens.

Eine Hochspannungsquelle 23 ist vorgesehen, um auch die Anodenblende 17 gegenüber der Kathode 5 elektrisch derart vorzuspannen, dass die Elektronen nach Durchlaufen der Anode 11 hin zu der Elektronenblende 17 weiter beschleunigt werden.

Eine Photonenquelle 27 ist vorgesehen, um einen im wesentlichen parallel kollimierten Photonenstrahl 29 zu erzeugen, welcher auf den Parabolspiegel 19 gerichtet ist. Die Photonenquelle 27 umfasst eine Halbleiterlaserdiode 31, welche Licht einer Wellenlänge von 650 nm divergent emittiert. Das divergent emittierte Licht wird durch eine Kollimationsoptik 33 kollimiert, um den im wesentlichen parallel kollimierten Strahl 29 zu formen. Der Strahl 29 tritt durch ein in einem Vakuummantel 35 der Elektronenstrahlquelle 1 vorgesehenes Fenster 37 in den Vakuumraum der Elektronenstrahlquelle 1 ein. Durch den Parabolspiegel 19 wird der Strahl 29 durch die Öffnung 12 der Anode 11 hindurch auf die Spitze des Kathodenkörpers 5 und damit auf die Quelloberfläche fokussiert, so dass die auf die Quelloberfläche treffenden Photonen eine Emission der Elektronen von der Quelloberfläche durch einen Photoeffektmechanismus unterstützen.

Eine Intensität des Photonenstrahls 29 ist einstellbar, indem eine Steuerung 39 eine der Laserdiode 31 zugeführte elektrische Leistung einstellt.

Ein Strommessgerät 41 ist in eine Verbindungsleitung 43 zwischen der Hochspannungsquelle 23 und der Blendenelektrode 17 eingefügt. Damit misst das Strommessgerät 41 einen zwischen dem Kathodenkörper 5 und der Blendenelektrode 17 fließenden Strom. Dieser ist bestimmt durch die Menge an Elektronen, welche pro Zeiteinheit von der Quelloberfläche emittiert werden und die Elektrodenblende 17 treffen, das heißt diese nicht durch deren Öffnung 18 durchsetzen. Damit repräsentiert das von dem Strommessgerät 41 bereitgestellte Messsignal die Intensität des Elektronenstrahls 3 nach Durchsetzen der Blendenelektrode 17 durch deren Öffnung 18.

Das Messsignal des Strommessgerätes 41 wird der Steuerung 39 zugeführt. Diese steuert dann die Laserdiode 31 der Photonenquelle 27 derart an, dass das Messsignal des Strommessgeräts 41 und damit auch die Intensität des Elektronenstrahls 3 in einem Normalbetrieb der Elektronenstrahlquelle 1 konstant gehalten wird.

Durch die Widerstandsheizung, d.h. den Stromfluss durch den Heizleiter 7, wird der Kathodenkörper und damit die Quelloberfläche auf eine Temperatur von etwa 1000 K geheizt. Dies ist eine Temperatur, bei der auch bei abgeschaltetem Photonenstrahl 29 bereits Elektronen aus der Quelloberfläche austreten und einen Elektronenstrahl formen. Dieser Strahl weist dann allerdings eine Intensität bzw. einen Strahlstrom auf, welcher nur etwa 80 % des Strahlstroms der Elektronenstrahlquelle 1 im Normalbetrieb, das heißt bei eingeschaltetem Photonenstrahl 29, beträgt.

Die Hochspannungsquelle 13 stellt eine Spannung von etwa 5 kV zwischen dem Kathodenkörper 5 und der Anodenblende 11 bereit, so dass das elektrische Extraktionsfeld an der Quelloberfläche eine Stärke von etwa 10⁶ V/cm aufweist.

Bei ausgeschaltetem Photonenstrahl 29 wirken die thermische Heizung des Kathodenkörpers und das Extraktionsfeld zusammen, um Elektronen aus der Quelloberfläche auszulösen, wie dies vorangehend in Zusammenhang mit dem Schottky-Effekt beschrieben wurde. Aufgrund der Beteiligung eines Tunneleffekts hieran ist die Elektronenstrahlintensität sehr stark abhängig von der Temperatur der Quelloberfläche, und geringste Schwankungen von Betriebszuständen der Elektronenstrahlquelle 1 können damit zu beträchtlichen Schwankungen der Stromstärke des Elektronenstrahls 3 führen. Derartige Schwankungen des Strahlstroms werden allerdings durch das Messgerät 41 erfasst und an die Steuerung 39 übermittelt, welche wiederum die Photonenquelle 27 im Hinblick auf eine Änderung der Intensität des Photonenstrahls 29 ansteuert, um Änderungen der Elektronenstrahlintensität über den Photoeffekt entgegenzuwirken. Der Elektronenstrahl 3 ist somit durch den Photonenstrahl 29 hinsichtlich seiner Strahlintensität stabilisiert. Gleichzeitig ist die Temperatur von 1000 K der Quelloberfläche im Vergleich zu herkömmlichen Schottky-Emittern relativ gering, was eine geringe Breite (FWHM) der Verteilung der kinetischen Energien der Elektronen in dem Elektronenstrahl 3 zur Folge hat. Die Energiebreite beträgt etwa 0,3 eV.

Somit stellt die Elektronenstrahlquelle 1 einen Elektronenstrahl 3 mit geringer Energiebreite und guter zeitlicher Konstanz bereit.

Die Photonenquelle 27 ist ferner derart ausgelegt, dass die Intensität des Photonenstrahls 29 in einem Ausheizbetrieb der Elektronenstrahlquelle 1 erhöht werden kann im Vergleich zur Intensität des Strahls 29 im Normalbetrieb der Elektonenstrahlquelle 1. Die Intensität des Photonenstrahls 29 kann dabei soweit erhöht werden, dass die Temperatur der Quelloberfläche durch die erhöhte Photonenintensität auf etwa 1300 K oder bis zu 1500 K im Vergleich zu etwa 1000 K im Normalbetrieb erhöht ist. Hierdurch ist es möglich, innerhalb einer kurzen Zeit von etwa 1 ms oder kürzer auf der Quelloberfläche abgelagerte Kontaminationen zu entfernen. Das elektrische Feld zum Extrahieren der Elektronen von der Quelloberfläche und zum Formen des Elektronenstrahls kann während des Ausheizbetriebs ausgeschaltet sein.

Nachfolgend werden Varianten der anhand der Figur 1 erläuterten Ausführungsform beschrieben. Hierin sind Komponenten, die Komponenten der Figur 1 hinsichtlich ihres Aufbaus und ihrer Funktion entsprechen, mit den Bezugsziffern der Figur 1 versehen, denen zur Unterscheidung jedoch ein zusätzlicher Buchstabe hinzugefügt ist. Es wird auf die gesamte vorangehende Beschreibung Bezug genommen.

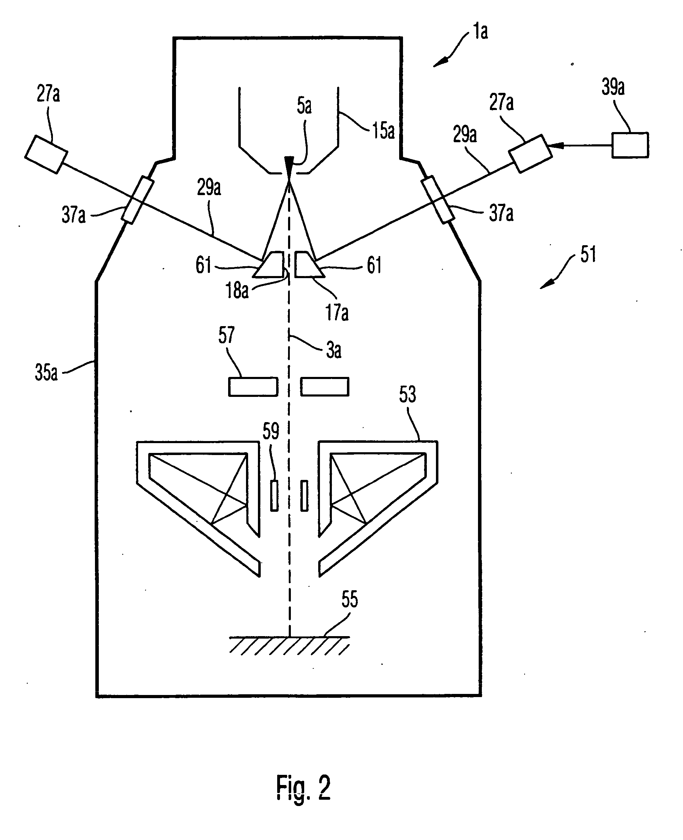

In Figur 2 ist ein Elektronenmikroskop 51 schematisch dargestellt. Dieses umfasst eine Elektronenquelle 1a zur Erzeugung eines Elektronenstrahls 3a, welcher von einer Objektivlinse 53 in einer Objektebene 55 fokussiert wird.

Von einem Objekt in der Objektebene 55 durch den fokussierten Elektronenstrahl 3a ausgelöste Sekundärelektronen durchsetzen die Objektivlinse 53 und treffen auf einen Elektronendetektor 57, um dort nachgewiesen zu werden. In einer Öffnung der Objektivlinse 53 sind Ablenkspulen 59 angeordnet, um einen Ort, an dem der Elektronenstrahl 3a in der Objektebene 55 fokussiert ist, in der Objektebene 55 zu verlagern. Eine Aufzeichnung der durch den Detektor 57 registrierten Sekundärelektronenintensität in Abhängigkeit von dem Fokusort des Strahls 3a in der Objektebene 55 liefert dann ein elektronenmikroskopisches Bild der Objektebene 55.

Die Elektronenquelle 1a weist einen ähnlichen Aufbau auf, wie die in Figur 1 gezeigte Elektronenquelle. So wird auch bei der Elektronenquelle 1a ein Kathodenkörper 5a, der innerhalb einer Suppressorelektrode 15a angeordnet ist, durch eine in Figur 2 nicht dargestellte Heizeinrichtung geheizt. Mit Abstand von dem Kathodenkörper 5a ist eine Anodenblende 17a mit einer zentralen Öffnung 18a angeordnet, welche von dem Elektronenstrahl 3a durchsetzt wird.

Im Unterschied zu der Blende 17 gemäß Figur 1 ist hier die Anodenblende 17a allerdings nicht mit einer parabolischen Spiegelfläche versehen. Vielmehr weist die Anodenblende 17a mehrere plane Spiegelflächen 61 auf, auf welche jeweils ein Laserstrahl 29a gerichtet ist, die jeweils durch Fenster 37a in einem Vakuummantel 35a des Elektronenmikroskops 51 eintreten.

Die Laserstrahlen 29a sind derart fokussiert, dass sie nach Reflexion an den Spiegelflächen 61 auf der Spitze des Kathodenkörpers 5a fokussiert sind. Die mehreren Strahlen 29a, welche von beispielsweise zwei, vier oder mehr in Umfangrichtung um den Elektronenstrahl 3a verteilt angeordneten Quellen 27a emittiert werden, treffen hierbei derart auf die im Hinblick auf Elektronenemission aktive Quelloberfläche, dass mehr als 60 % derselben, insbesondere mehr als 80 % derselben oder diese im wesentlichen vollständig beleuchtet wird.

Auch bei dieser Ausführungsform sind ein Messgerät zur Messung des Elektronenstrahls 3a über dem auf die Anodenblende 17a treffenden Strom, eine Steuerung 39a und einstellbare Lichtquellen 27a für die Strahlen 29a vorgesehen, um die Intensität der Laserstrahlen 29a in Abhängigkeit von dem Elektronenstrahlstrom anzusteuern, und zwar im Hinblick darauf, die Intensität des Elektronenstroms 3a konstant zu halten.

Auch bei dem Elektronenmikroskop 51 emittiert die Elektronenstrahlquelle 1a in einem von dem Normalbetrieb abweichenden Betriebsmodus, in dem die Laserstrahlen 29a ausgeschaltet sind, eine Elektronenstrahlintensität, die etwa 80 % der Intensität des Elektronenstrahls 3a im Normalbetrieb beträgt.

In der Ausführungsform der Figur 1 sind eine Anodenblende 11 und eine weitere Anodenblende 17 im Strahlengang des Elektonenstrahls hintereinander vorgesehen. Die im Strahlengang erste Anodenblende 11 wird auch häufig als Extraktor bezeichnet. Es ist bei dieser Ausführungsform jedoch auch möglich, lediglich eine Anodenblende vorzusehen, wenn dies für die Formung des Strahls ausreicht. Alternativ zu der in Figur 1 gezeigten Ausführungsform, kann auch der auf die erste Anodenblende 11 treffende Strahlstrom gemessen und von der Steuerung 39 erfaßt werden, um die Photonenstrahlintensität entsprechend anzusteuern bzw. zu regeln.

Auch in der Figur 2 ist es möglich, eine weitere Anodenblende bzw. ein Extraktor, zwischen der Anode 17a und dem Kathodenkörper 5a vorzusehen. Hierbei ist es möglich, die Aperturöffnung einer solchen weiteren Anodenblende so groß zu wählen, dass sie auch von den Photonenstrahlen 29a durchsetzt wird. Es ist ebenfalls möglich, eine zentrale kleine Aperturöffnung für den Durchtritt des Elektronenstrahls 3 auch vorzusehen und hiervon separate weitere Ausnehmungen für den Durchtritt der Lichtstrahlen 29a vorzusehen.

Neben der Messung des Strahlstroms über die Messung eines auf eine Anodenblende treffenden Elektronenstroms ist es auch möglich, an einer anderen Stelle der Anordnung den Strahlstrom zu messen, beispielsweise über die Messung eines Stroms, den der Elektronenstrahl auf eine zu untersuchende Probe transportiert, d.h. es wird dann der von der Probe abfließende Strom gemessen.

Eine Abwandlung des in Figur 2 gezeigten Elektronenmikroskops erlaubt es, diese Apparatur als ein Lithographiegerät zu betreiben. Es wird dann die Heizung des Kathodenkörpers nur vermindert betrieben bzw. gar nicht bereitgestellt (nicht beansprucht). Die Photonenstrahlen 29a und das durch die Anodenblende 17a erzeugte Extraktionsfeld wirken alleine zusammen, um die Elektronen zur Bildung des Strahls 3a aus der Quelloberfläche auszulösen. Somit wird bei abgeschaltetem Laserstrahl 29a kein Elektronenstrahl 3a emittiert. Es ist dann möglich, durch Auslenken des Elektronenstrahls 3a durch die Ablenkspulen 59 und Ein- und Ausschalten des Elektronenstrahls 3a über Ein- und Ausschalten der Laserstrahlen 29a ein Muster auf eine strahlungsempfindliche Schicht ("resist") zu schreiben, welche in der Objektebene 55 angeordnet ist.

Hierbei ist es häufig gewünscht, das Muster mit "Graustufen" zu schreiben, d.h. nicht nur binäre Muster durch Ein- und Ausschalten Strahls zu erzeugen sondern Übergänge zwischen einer voll belichteten und einer gar nicht belichteten strahlungsempfindlichen Schicht zu erzeugen. Hierfür ist es wesentlich, eine durch den Elektronenstrahl 3a an einem durch die Auslenkung mittels der Ablenkspulen 59 vorgegebenen Ort genau in Abhängigkeit von einer Empfindlichkeitskennlinie der strahlungsempfindlichen Schicht einzustellen. Dies bedeutet, in einem jeden Ort soll es möglich sein, eine vorbestimmte Menge an Elektronen, d.h. eine vorbestimmte Ladung, zu deponieren. Es ist hierzu vorgesehen, dass die Steuerung 39a den auf die Anodenblende 17a treffenden Elektronenstrom integriert und bei Erreichen eines Schwellenwerts des Integrals die Laserlichtquellen 27a ausschaltet. Diese Prozedur wird für einen jeden Ort bzw. Pixel in der Objektebene 55 wiederholt.

In den vorangehend beschriebenen Ausführungsformen trifft der Photonenstrahl jeweils von der Seite der Anodenblende auf die Quelloberfläche. Es ist jedoch auch möglich, den Photonenstrahl von einer entgegengesetzten Seite auf die Quelloberfläche zu richten, wie dies beispielsweise in US 5,808,309 oder US 6,376,985 B2 offenbart ist.

Ferner ist die Quelloberfläche in den vorangehend beschriebenen Ausführungsformen durch Bariumoxid bereitgestellt, welches auf eine Wolframspitze aufgetragen ist. Alternativ hierzu ist es möglich, Oxide oder Nitride der Elemente Yttrium, Scandium, Vanadium, Lanthan, Zirkon, Titan oder Mischungen derselben auf geeignete Kathodenkörper aufzutragen.

In den vorangehend beschriebenen Ausführungsformen wird die Intensität des Photonenstrahls durch Ändern einer der Laserquelle zugeführten elektrischen Intensität eingestellt. Es ist jedoch auch möglich, die Intensität des Photonenstrahls durch andere Maßnahmen zu ändern, beispielsweise durch das Einfügen einer durch die Steuerung ansteuerbaren Pockels-Zelle mit Polarisator oder einen Niedervoltmodulator in den Strahlengang.

Zusammenfassend wird eine Elektronenstrahlquelle 1 vorgeschlagen, deren Quelloberfläche mittels eines Photonenstrahls beleuchtet wird, dessen Intensität variabel ist. Der Photonenstrahl unterstützt die Emission der Elektronen von der Quelloberfläche durch einen Photoeffekt. Ergänzend hierzu wird noch ein Extraktionsfeld bereitgestellt, um Elektronen aus der Quelloberfläche auszulösen und auch noch eine Heizeinrichtung vorgesehen, um die Emission der Elektronen aus der Quelloberfläche thermisch zu unterstützen. Ein Elektronenstrahlstrom wird gemessen, und die Intensität der Photonenquelle wird in Abhängigkeit von dem gemessenen Elektronenstrahlstrom eingestellt.

## Patentansprüche

1. Elektronenstrahlquelle zur Erzeugung eines Strahls (3) von Elektronen, umfassend:
- einen Kathodenkörper (5) mit einer Quelloberfläche zur Emission von Elektronen,
- eine mit Abstand von dem Kathodenkörper angeordnete Anode (11, 17a) zur Bereitstellung eines Extraktionsfeldes zur Extraktion der Elektronen aus der Quelloberfläche,
- eine Heizeinrichtung (7) zum Heizen des Kathodenkörpers (5),
- eine Photonenquelle (27), zur Erzeugung wenigstens eines auf die Quelloberfläche gerichteten Photonenstrahls (29), um die Emission der Elektronen zu unterstützen, wobei die Photonenquelle (27) derart ausgebildet ist, dass eine Intensität des wenigstens einen Photonenstrahls änderbar ist, **gekennzeichnet durch**
- eine Messeinrichtung (41) zur Erfassung eines Strahlstroms des Elektronenstrahls (3) und zur Ausgabe eines den Strahlstrom von Elektronen repräsentierenden Messsignals, und
- eine Steuerung (39), welche dazu ausgebildet ist, in einem Normalbetriebsmodus der Elektronenstrahlquelle die Photonenquelle (27) in Abhängigkeit von dem Messsignal zur Änderung der Intensität des Photonenstrahls anzusteuern,
wobei der Strahlstrom des Elektronenstrahls (3) in einem von dem Normalbetriebsmodus verschiedenen Betriebsmodus, in dem der Photonenstrahl nicht auf die Quelloberfläche gerichtet ist, größer ist als ein 0,3-faches des Strahlstroms in dem Normalbetriebsmodus, insbesondere größer als ein 0,65-faches und insbesondere größer als ein 0,8-faches des Strahlstroms in dem Normalbetriebsmodus.

2. Elektronenstrahlquelle nach Anspruch 1, wobei eine maximale Intensität des Photonenstrahls (29) in dem Normalbetriebsmodus derart beschränkt ist, dass sich die Quelloberfläche in einem von dem Normalbetriebsmodus verschiedenen Betriebsmodus, in dem dem Kathodenkörper (5) neben dem Photonenstrahl (29) mit der maximalen Intensität in dem Normalbetriebsmodus keine weitere Energie zugeführt wird, nicht über eine Temperatur von 1300 K erhitzt, insbesondere nicht über 900 K und weiter bevorzugt nicht über 600 K erhitzt.

3. Elektronenstrahlquelle nach Anspruch 1 oder 2, wobei die Heizeinrichtung (7) eine elektrische Widerstandsheizung umfasst.

4. Elektronenstrahlquelle nach einem der Ansprüche 1 bis 3, wobei die Steuerung (39) dazu ausgebildet ist, die Photonenquelle (27) derart anzusteuern, dass der Strahlstrom im Normalbetrieb im wesentlichen zeitlich konstant ist.

5. Elektronenstrahlquelle nach einem der Ansprüche 1 bis 4, wobei in einem Strahlengang des Photonenstrahls (29) zwischen der Photonenquelle (27) und der Quelloberfläche ein den Photonenstrahl (29) umlenkender Spiegel (19) vorgesehen ist.

6. Elektronenstrahlquelle nach Anspruch 5, wobei der Spiegel (19) an einer von dem Elektronenstrahl (3) durchsetzten Aperturblende (17) für den Elektronenstrahl (3) bereitgestellt ist.

7. Elektronenstrahlquelle nach Anspruch 5 oder 6, wobei der Spiegel ein Fokussierspiegel, insbesondere ein Spiegel (19) mit einer im wesentlichen parabolförmigen Spiegelfläche ist.

8. Elektronenstrahlquelle nach einem der Ansprüche 1 bis 7, wobei mehrere Photonenstrahlen (29a) auf die Quelloberfläche gerichtet sind.

9. Elektronenstrahlquelle nach einem der Ansprüche 1 bis 10, wobei die Messeinrichtung (41) eine Intensität von auf eine von dem Elektronenstrahl durchsetzte Strahlblende (11), insbesondere die Anode (17a), treffenden emittierten Elektronen erfasst.

10. Elektronenstrahlquelle nach einem der Ansprüche 1 bis 9, wobei ein die Quelloberfläche des Kathodenkörpers (5) bereitstellendes Material Bariumoxid umfasst und wobei insbesondere die Quelloberfläche im wesentlichen aus Bariumoxid besteht.

11. Elektronenstrahlquelle nach einem der Ansprüche 1 bis 10, wobei in dem Normalbetriebsmodus der Elektronenstrahlquelle die Quelloberfläche eine Arbeitstemperatur aufweist und wobei die Photonenquelle dazu ausgebildet ist, in einem von dem Normalbetriebsmodus verschiedenen Ausheizbetriebsmodus die Intensität des Photonenstrahls derart zu erhöhen, dass die Temperatur der Quelloberfläche in dem Ausheizbetriebsmodus die Arbeitstemperatur um mehr als 100°K, insbesondere mehr als 200°K und weiter bevorzugt um mehr als 300°K übersteigt.

12. Elektronenoptischer Apparat, insbesondere Elektronenmikroskop, mit einer Elektronenstrahlquelle nach einem der Ansprüche 1 bis 11.

13. Verfahren zum Betrieb einer Elektronenstrahlquelle, welche einen Kathodenkörper mit einer Quelloberfläche aufweist, und wobei das Verfahren umfasst:
Betreiben der Elektronenstrahlquelle in einem Normalbetriebsmodus, wobei in dem Normalbetriebsmodus - der Kathodenkörper mit einer Heizeinrichtung geheizt wird,
- die Quelloberfläche mit einem Photonenstrahl änderbarer Intensität beleuchtet wird,
- Elektronen aus der Quelloberfläche extrahiert werden und die extrahierten Elektronen zu dem Elektronenstrahl geformt werden, **dadurch gekennzeichnet, daß**
- eine einer Intensität des geformten Elektronenstrahls repräsentierende Größe gemessen wird, und
- eine Intensität des Photonenstrahls in Abhängigkeit von der gemessenen Größe geändert wird,
wobei der Kathodenkörper in dem Normalbetriebsmodus derart geheizt wird, dass in einem von dem Normalbetriebsmodus verschiedenen Betriebsmodus, in welchem die Quelloberfläche nicht mit dem Photonenstrahl beleuchtet wird und der Kathodenkörper wie in dem Normalbetriebsmodus geheizt wird, die Intensität des geformten Elektronenstrahls größer als ein 0,3-faches der Intensität des geformten Elektronenstrahls in dem Normalbetriebsmodus, und wobei die Intensität des geformten Elektronenstrahls in dem von dem Normalbetriebsmodus verschiedenen Betriebsmodus insbesondere größer als ein 0,65-faches und insbesondere größer als ein 0,8-faches der Intensität in dem Normalbetriebsmodus ist.

14. Verfahren nach Anspruch 13, ferner umfassend:
Betreiben der Elektronenstahlquelle in einem Ausheizbetriebsmodus, wobei in dem Ausheizbetriebsmodus die Intensität des Photonenstrahls während einer Zeitdauer im Vergleich zu der Intensität des Photonenstrahls in dem Normalbetriebsmodus derart erhöht wird, dass eine Temperatur der Quelloberfläche um mehr als 100°K, insbesondere mehr als 200°K und weiter bevorzugt um mehr als 300°K, erhöht wird im Vergleich zu der Temperatur der Quelloberfläche in dem Normalbetriebsmodus.

## Claims

1. An electron beam source for generating a beam (3) of electrons, said electron beam source comprising:
- a cathode body (5) having a source surface for emitting electrons,
- an anode (11, 17a) disposed at a distance from the cathode body for generating an extraction field for extracting the electrons from the source surface,
- a heater (7) for heating the cathode body (5),
- a photon source (27) for generating at least one photon beam (29) directed onto the source surface for assisting in the emission of the electrons, wherein the photon source (27) is configured such that an intensity of the at least one photon beam is adjustable,
**characterized by**
- a measuring device (41) for detecting a beam current of the electron beam (3) and for providing a measuring signal representing the current of the electron beam, and
- a controller (39) configured to control, in a normal mode of operation of the electron beam source, the photon source (27) based on the measuring signal to change the intensity of the photon beam,
wherein, in a mode of operation which is different from the normal mode of operation and in which the photon beam is not directed onto the source surface, the electron beam current (3) is higher than 0.3 times the electron beam current in the normal mode of operation, in particular higher than 0.65 times, and in particular higher than 0.8 times the beam current in the normal mode of operation.

2. The electron beam source according to claim 1, wherein a maximum intensity of the photon beam (29) in the normal mode of operation is limited in such a way that, in a mode of operation which is different from the normal mode of operation and in which no other energy is supplied to the cathode body (5) apart from the photon beam (29), a temperature of the source surface is not heated above a temperature of 1300 K, in particular no more than 900 K, and further preferred no more than 600 K.

3. The electron beam source according to claim 1 or 2, wherein the heater (7) comprises an electrical resistance heater.

4. The electron beam source according to one of claims 1 to 3, wherein the controller (39) is configured to control the photon source (27) such that the beam current is substantially constant in time in the normal mode of operation.

5. The electron beam source according to one of claims 1 to 4, wherein a mirror (19) deflecting the photon beam (29) is disposed in a beam path of the photon beam (29) between the photon source (27) and the source surface.

6. The electron beam source according to claim 5, wherein the mirror (19) is provided at an aperture beam stop (17) traversed by the electron beam (3).

7. The electron beam source according to claims 5 or 6, wherein the mirror (19) is a focusing mirror, in particular a mirror (19) having a substantially parabolic mirror surface.

8. The electron beam source according to one of claims 1 to 7, wherein plural photon beams (29a) are directed onto the source surface.

9. The electron beam source according to one of claims 1 to 10, wherein the measuring device (41) detects an intensity of emitted electrons incident on a beam aperture (11), in particular the anode (17a), traversed by the electron beam.

10. The electron beam source according to one of claims 1 to 9, wherein the source surface of the cathode body (5) is made of a material comprising barium oxide, and wherein in particular the source surface is substantially made of barium oxide.

11. The electron beam source according to one of claims 1 to 10, wherein, in the normal mode of operation of the electron beam source, the source surface is at a working temperature, and wherein the photon source is configured to increase, in an annealing mode of operation which is different from the normal mode of operation, the intensity of the photon beam such that the temperature of the source surface, in the annealing mode of operation, exceeds the working temperature in the annealing mode of operation by more than about 100° K, in particular by more than 200°K, and further preferred by more than 300°K.

12. An electron optical apparatus, in particular an electron microscope, comprising an electron source according to one of claims 1 to 11.

13. A method for operating an electron beam source comprising a cathode body having a source surface, said method comprising:
operating the electron beam source in a normal mode of operation, wherein, in the normal mode of operation,
- the cathode body is heated by means of a heater,
- the source surface in illuminated with a photon beam of an adjustable intensity,
- electrons are extracted from the source surface, and the extracted electrons are shaped to form the electron beam,
**characterized in that**
- a quantity representing an intensity of the thus shaped electron beam is measured, and
- an intensity of the photon beam is changed depending on the measured quantity,
wherein the cathode body is heated in the normal mode of operation such that, in a mode of operation which is different from the normal mode of operation and in which the source surface is not illuminated with the photon beam and the cathode body is heated in the same manner as in the normal mode of operation, the intensity of the shaped electron beam is more than 0.3 times the intensity of the shaped electron beam in the normal mode of operation, and wherein the intensity of the shaped electron beam in the mode of operation which is different from the normal mode of operation is in particular more than 0.65 times, and in particular more than 0.8 times the intensity of the normal mode of operation.

14. The method according to claim 13, further comprising:
operating the electron beam source in an annealing mode of operation, wherein, in the annealing mode of operation, the intensity of the photon beam is increased as compared to the intensity of the photon beam in the normal mode of operation over a period of time such that a temperature of the source surface is higher than the temperature of the source surface in the normal mode of operation by more than about 100° K, in particular more than 200°K, and further preferred more than 300°K as compared to the temperature of the source surface in the normal mode of operation.

## Revendications

1. Source de faisceau d'électrons pour la production d'un faisceau (3) d'électrons, comprenant:
- un corps de cathode (5) avec une surface de source pour l'émission d'électrons,
- une anode (11, 17a) agencée à distance du corps de cathode pour la mise à disposition d'un champ d'extraction en vue de l'extraction des électrons depuis la surface de source,
- un dispositif de chauffage (7) pour chauffer le corps de cathode (5),
- une source de photons (27) pour la production d'au moins un faisceau de photons (29) orienté sur la surface de source, afin de favoriser l'émission d'électrons, la source de photons (27) étant réalisée de façon à ce que l'intensité du au moins un faisceau de photons puisse être modifiée, **caractérisée par**
- un dispositif de mesure (41) destiné à enregistrer un courant du faisceau d'électrons (3) et à émettre un signal de mesure représentant le courant du faisceau d'électrons, et
- une commande (39), laquelle est réalisée pour commander, en mode de fonctionnement normal de la source de faisceau d'électrons, la source de photons (27) en fonction du signal de mesure afin de modifier l'intensité du faisceau de photons,
le courant du faisceau d'électrons (3), dans un mode de fonctionnement différent du mode de fonctionnement normal, dans lequel le faisceau de photons n'est pas orienté sur la surface de source, étant supérieur à 0,3 fois le courant de faisceau en mode de fonctionnement normal, en particulier supérieur à 0,65 fois et plus particulièrement supérieur à 0,8 fois le courant de faisceau en mode de fonctionnement normal.

2. Source de faisceau d'électrons selon la revendication 1, dans laquelle l'intensité maximale du faisceau de photons (29) en mode de fonctionnement normal est limitée de façon à ce que la surface de source, dans un mode de fonctionnement différent du mode de fonctionnement normal, dans lequel le corps de cathode (5), outre le faisceau de photons (29) d'intensité maximale en mode de fonctionnement normal n'est pas alimenté par une autre énergie, ne chauffe pas à une température au-delà de 1300 K, en particulier pas au-delà de 900 K, et de façon davantage préférée, pas au-delà de 600 K.

3. Source de faisceau d'électrons selon la revendication 1 ou 2, dans laquelle le dispositif de chauffage (7) comprend un chauffage à résistance électrique.

4. Source de faisceau d'électrons selon l'une des revendications 1 à 3, dans laquelle la commande (39) est conçue pour exciter la source de photons (27) de façon à ce que le courant de faisceau en fonctionnement normal soit essentiellement constant dans le temps.

5. Source de faisceau d'électrons selon l'une des revendications 1 à 4, dans laquelle il est prévu dans la trajectoire du faisceau de photons (29), entre la source de photons (27) et la surface de source, un miroir (19) qui renvoie le faisceau de photons (29).

6. Source de faisceau d'électrons selon la revendication 5, dans laquelle le miroir (19) est disposé au niveau d'un diaphragme (17) traversé par le faisceau d'électrons (3) pour le faisceau d'électrons (3).

7. Source de faisceau d'électrons selon la revendication 5 ou 6, dans laquelle le miroir est un miroir de focalisation, en particulier un miroir (19) avec une surface de miroir essentiellement parabolique.

8. Source de faisceau d'électrons selon l'une des revendications 1 à 7, dans laquelle plusieurs faisceaux de photons (29a) sont orientés sur la surface de source.

9. Source de faisceau d'électrons selon l'une des revendications 1 à 8, dans laquelle le dispositif de mesure (41) détermine l'intensité d'électrons émis venant se heurter à un obturateur de faisceau (11) traversé par le faisceau d'électrons, en particulier l'anode (17a).

10. Source de faisceau d'électrons selon l'une des revendications 1 à 9, dans laquelle un matériau constituant la surface de source du corps de cathode (5) contient de l'oxyde de baryum et dans laquelle en particulier la surface de source se compose pour l'essentiel d'oxyde de baryum.

11. Source de faisceau d'électrons selon l'une des revendications 1 à 10, dans laquelle, en mode de fonctionnement normal de la source de faisceau d'électrons, la surface de source présente une température de travail et dans laquelle la source de photons est conçue, dans un mode de fonctionnement chauffage différent du mode de fonctionnement normal, pour augmenter l'intensité du faisceau de photons de sorte que la température de la surface de source en mode de fonctionnement chauffage dépasse la température de travail de plus de 100°K, en particulier de plus de 200°K, et de façon davantage préférée de plus de 300°K.

12. Appareil optique à électrons, en particulier microscope à électrons, comprenant une source de faisceau d'électrons selon l'une des revendications 1 à 11.

13. Procédé pour le fonctionnement d'une source de faisceau d'électrons présentant un corps de cathode avec une surface de source, le procédé comprenant les étapes consistant à:
faire fonctionner la source de faisceau d'électrons en mode de fonctionnement normal, dans lequel
- le corps de cathode est chauffé à l'aide d'un dispositif de chauffage,
- la surface de source est éclairée avec un faisceau de photons d'intensité variable,
- les électrons sont extraits de la surface de source et les électrons extraits sont constitués en un faisceau d'électrons, **caractérisé en ce que**
- il est mesuré une valeur représentant l'intensité du faisceau d'électrons formé, et **en ce que**
- l'intensité du faisceau de photons est modifiée en fonction de la valeur mesurée,
le corps de cathode, en mode de fonctionnement normal, étant chauffé de façon à ce que dans un mode de fonctionnement différent du mode de fonctionnement normal, dans lequel la surface de source n'est pas éclairée par le faisceau de photons et le corps de cathode est chauffé comme dans le mode de fonctionnement normal, l'intensité du faisceau d'électrons formé soit supérieure à 0,3 fois l'intensité du faisceau d'électrons formé en mode de fonctionnement normal, l'intensité du faisceau d'électrons formé dans le mode de fonctionnement différent du mode de fonctionnement normal étant en particulier supérieure à 0,65 fois et plus particulièrement supérieure à 0,8 fois l'intensité en mode de fonctionnement normal.

14. Procédé selon la revendication 13, consistant en outre à:
faire fonctionner la source de faisceau d'électrons dans un mode de fonctionnement chauffage, dans lequel l'intensité du faisceau de photons est accrue sur un certain laps de temps par rapport à l'intensité du faisceau de photons en mode de fonctionnement normal, de sorte que la température de la surface de source est augmentée de plus de 100°K, en particulier de plus de 200°K, et de façon davantage préférée de plus de 300°K par rapport à la température de la surface de source en mode de fonctionnement normal.
